# DEMANDE DE BREVET EUROPEEN

(11) **EP 3 176 829 A1**
(43) Date de publication de la demande: **07.06.2017**
(21) Numéro de dépôt: 16200031.9
(22) Date de dépôt: 22.11.2016
(51) Int. Cl.: H01L 31/0224, H01L 31/0749

(54) **CELLULE PHOTOVOLTAÏQUE EN COUCHES MINCES ET PROCÉDÉ DE FABRICATION ASSOCIÉ**

(30) Priorité: 02.12.2015 FR 1561713
(71) Demandeur: COMMISSARIAT À L'ÉNERGIE ATOMIQUE ET AUX ÉNERGIES ALTERNATIVES, 75015 Paris (FR)
(72) Inventeur: GRENET, Louis, 38000 Grenoble (FR); DELLEA, Olivier, 42350 La Talaudiere (FR); EMIEUX, Fabrice, 38340 Voreppe (FR)
(74) Mandataire: Brunelli, Gérald

(57) **Abrégé**

Cellule photovoltaïque en couches minces comprenant une couche de substrat (2) pour cellule photovoltaïque et une grille de molybdène (3) disposée sur la couche de substrat (2), une couche ultra-mince d'alliage (4) de cuivre, d'indium, de gallium et de sélénium disposée sur la grille de molybdène, ainsi qu'une couche tampon (5) disposée sur la couche ultra-mince d'alliage (4) de cuivre, d'indium, de gallium et de sélénium et une couche fenêtre (6) disposée sur la couche tampon.

## Description

L'invention porte sur un agencement pour empilement de cellule photovoltaïque en couches minces et un procédé de fabrication associé.

Une cellule photovoltaïque est un composant électronique qui, exposé à la lumière, génère de l'électricité. Elle peut être utilisée seule (calculatrice, montre...) mais, la plupart du temps, les cellules sont regroupées dans des modules ou panneaux photovoltaïques.

Il existe plusieurs familles de cellules photovoltaïques, dont les plus répandues sont les cellules en silicium cristallin et les cellules en couches minces.

Les technologies dites couches minces sont basées sur l'utilisation de couches extrêmement fines de l'épaisseur de quelque microns et consistent à déposer sous vide sur un substrat (généralement en verre, vitrocéramique, métal, plastique, ...) une fine couche uniforme composée d'un ou plus généralement de plusieurs matériaux réduits en poudre.

Les cellules en couches minces sont fabriquées en déposant une ou plusieurs couches semi-conductrices et photosensibles sur un support ou substrat de verre, de vitrocéramique, de plastique, ou d'acier... Cette technologie permet de diminuer le coût de fabrication. La technologie des cellules en couches minces connaît actuellement un fort développement.*

Les cellules photovoltaïques dont la couche absorbeur est à base d'alliage de cuivre Cu, d'indium In, de gallium Ga, et de sélénium Se, connues sous la dénomination "CIGS", sont actuellement les cellules solaires en couches minces présentant les meilleurs rendements de conversion photovoltaïque (21,7%), comme divulgué dans le document "Properties of Cu(In,Ga)Se2 solar cells with new record deficiencies up to 21,7%", de Jackson P., Hariskos D., Wuerz R., Kiowski O., Bauer A., Friedlmeier T.M., et Powalla M., (2014); physica status solidi (RRL)-Rapid Research Letters, 9999. La formule générale du CIGS peut donc s'écrire Culn₁₋ₓGaₓS_{2(1-y)}Se_{2y} avec 0 ≤x ≤1 et 0 ≤y ≤1. Généralement, x≈0.3 et y=1.

La structure générale d'une telle cellule photovoltaïque comprend du Molybdène Mo, du CIGS, du sulfure de cadmium CdS, et d'un oxyde transparent conducteur TCO (généralement constitué d'une bicouche de ZnO/Zno:Al ou ZnO/ITO). La rareté de l'indium In peut être un frein au développement de cette technologie à grande échelle.

Pour faire face à ce problème il est envisagé de réduire l'épaisseur de la couche active en CIGS, comme divulgué dans le document " Influence of the Cu (In, Ga) Se2 thickness and Ga grading on solar cell performance." De Lundberg O., Bodegård M., Malmström J., et Stolt L. (2003); Progress in Photovoltaics: Research and Applications, 11 (2), 77-88.

Lorsque la couche active de CIGS est réduite en épaisseur, les recombinaisons de porteurs en face arrière deviennent sensibles et réduisent notablement la tension électrique Voc en circuit ouvert de la cellule solaire.

Des travaux ont montré qu'introduire par exemple une couche d'alumine entre le Mo et le CIGS avec des trous localisés permet de réduire ces recombinaisons et d'augmenter le Voc, tel que divulgué dans le document "Employing Si solar cell technology to increase efficiency of ultra-thin Cu(In, Ga)Se2 solar cells." de Vermang B., Wätjen J. T., Fjällsträm V., Rostvall F., Edoff M., Kotipalli R., et Flandre D. (2014); Progress in Photovoltaics: Research and Applications, 22(10), 1023-1029. Ce document divulgue une méthode de dépôt de couche de diélectrique entre le Mo et le CIGS et son ouverture localement grâce à un dépôt préalable de billes ou microsphères de sulfure de cadmium CdS puis décollage/arrachage ou grâce à la lithographie optique.

Bien sûr, cela s'applique également à une couche active à base d'alliage de cuivre Cu, de zinc Zn, de l'étain Sn, ainsi que de sélénium Se et/ou de soufre S, connue sous la dénomination "CZTS", dont la formule générale peut donc s'écrire Cu₂ZnSnS_{4(1-y)}Se_{4y} avec 0 ≤ y ≤1.

Un but de l'invention est de pallier les problèmes précédemment cités, et notamment de limiter les zones de contact électrique direct entre l'alliage CIGS ou CZTS et le molybdène Mo pour limiter les pertes par recombinaisons en face arrière.

Il est proposé, selon un aspect de l'invention, un agencement pour empilement de cellule photovoltaïque en couches minces comprenant une couche de substrat pour cellule photovoltaïque et une grille de molybdène ou couche de molybdène discontinue disposée sur la couche de substrat, une couche ultra-mince d'absorbeur de lumière recouvrant la grille de molybdène et comblant les trous de la grille de molybdène, ainsi qu'une couche tampon disposée sur la couche ultra-mince d'absorbeur de lumière et une couche fenêtre disposée sur la couche tampon.

La grille de molybdène, ou en d'autres termes le molybdène en couche non continue, permet de limiter les zones de contact électrique direct entre l'alliage CIGS et le molybdène Mo pour limiter les pertes par recombinaisons en face arrière.

On entend par couche ultra-mince d'absorbeur de lumière une couche d'épaisseur comprise entre comprise entre 50 nm et 2.5 µm.

La couche ultra-mince d'absorbeur de lumière peut être en CIGS, i.e. en alliage de cuivre, d'indium, de gallium et de sélénium.

En variante, la couche ultra-mince d'absorbeur de lumière peut être en CZTS, i.e. en alliage de cuivre, de zinc, d'étain, ainsi que de sélénium et/ou de soufre.

Selon un mode de réalisation, l'agencement comprend une couche de diélectrique disposée entre la couche de substrat et la grille de molybdène.

L'absence de diélectrique supprime une étape de dépôt et permet donc de diminuer le coût de réalisation. En revanche, la présence d'un diélectrique adapté, par exemple à base de dioxyde de titane TiO₂ ou d'alumine Al₂O₃ permet une meilleure passivation du contact arrière.

Dans un mode de réalisation, l'agencement comprend une couche de métal réfléchissant disposée entre la couche de substrat et la couche de diélectrique.

Cette fine couche, de quelques nanomètres à une centaine de nanomètres, d'un métal très réfléchissant, comme l'aluminium Al, l'argent Ag, l'or Au, le platine Pt, ou le molybdène Mo, permet d'augmenter le courant électrique dans la cellule comprenant du CIGS. Un métal alternatif plus réfléchissant que le molybdène Mo peut être utilisé car il est protégé pendant l'étape de recuit de sélénisation par la couche diélectrique.

Selon un autre aspect de l'invention, il est également proposé un procédé de fabrication d'un agencement pour empilement de cellule photovoltaïque en couches minces comprenant les étapes de :
- fourniture d'un substrat pour cellule photovoltaïque;
- dépôt d'un tapis de microsphères sur ledit substrat;
- dépôt de molybdène sur le tapis de microsphères dont une partie se glisse dans les interstices séparant les microsphères;
- enlèvement des microsphères laissant une grille de molybdène;
- dépôt d'une couche ultra-mince d'absorbeur de lumière sur la grille de molybdène; et
- dépôt d'une couche tampon et d'une couche fenêtre sur la couche ultra-mince d'absorbeur de lumière.

L'absorbeur de lumière peut être du CIGS ou du CZTS

Dans un mode de mise en oeuvre, le procédé comprend, en outre, une étape de traitement des microsphères, après leur dépôt et avant l'étape de dépôt de molybdène, modifiant la géométrie des microsphères, par exemple par gravure et/ou recuit.

Une telle étape de traitement des microsphères permet de modifier la géométrie des microsphères, leur taille et leur forme, et ainsi de pouvoir gérer le dimensionnement de la grille de molybdène lors du dépôt de molybdène Mo.

Selon un mode de mise en oeuvre, le procédé comprend, en outre, une étape de dépôt d'une couche de diélectrique sur le substrat avant le dépôt des microsphères; la couche de diélectrique se trouvant alors entre le substrat et le tapis de microsphères.

L'absence de diélectrique supprime une étape de dépôt et permet donc de diminuer le coût de réalisation. En revanche, la présence d'un diélectrique adapté, par exemple à base de dioxyde de titane TiO₂ ou d'alumine Al₂O₃ permet une meilleure passivation du contact arrière.

Dans un mode de mise en oeuvre, le procédé comprend, en outre, une étape de dépôt d'un métal réfléchissant, avant le dépôt de la couche de diélectrique; la couche de métal réfléchissant étant alors disposée entre la couche de substrat et la couche de diélectrique.

Cette fine couche, de quelques nanomètres à une centaine de nanomètres, d'un métal très réfléchissant, comme l'aluminium Al, l'argent Ag, l'or Au, le platine Pt, ou le molybdène Mo, permet d'augmenter le courant électrique dans la cellule comprenant du CIGS. Un métal alternatif plus réfléchissant que le molybdène Mo peut être utilisé car il sera protégé pendant l'étape de recuit de sélénisation par la couche diélectrique.

Selon un mode de mise en oeuvre, le dépôt de la couche de molybdène sur les microsphères est fait sur une épaisseur comprise entre 100 et 2000 nm, et avantageusement sur une épaisseur de sensiblement 500 nm.

Dans un mode de mise en oeuvre, le dépôt du tapis de microsphères met en oeuvre des microsphères de diamètre compris entre 100 nm et 5 µm, et avantageusement de diamètre de sensiblement 1 µm.

Selon un mode de mise en oeuvre, l'enlèvement des microsphères met en oeuvre un bain d'ultra-sons dans l'eau entre 10 s et 10 min, et avantageusement 1 min.

L'invention sera mieux comprise à l'étude de quelques modes de réalisation décrits à titre d'exemples nullement limitatifs et illustrés par les dessins annexés sur lesquels :

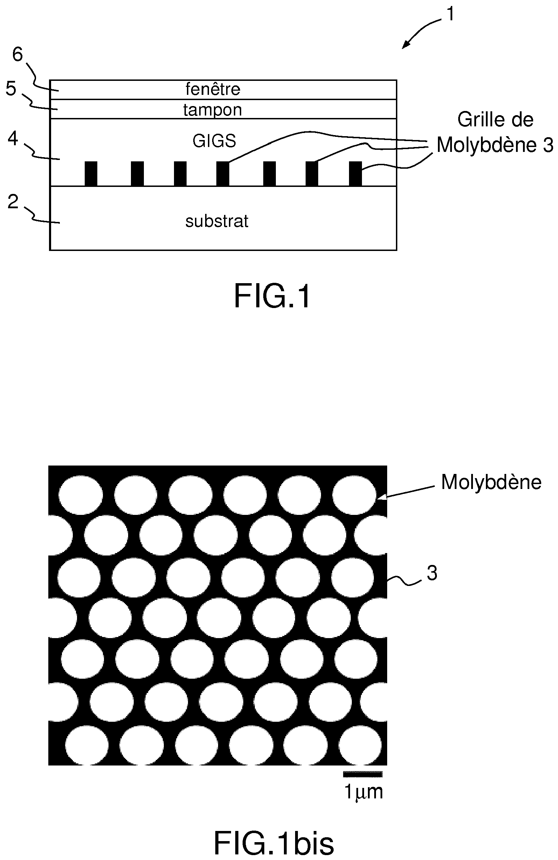

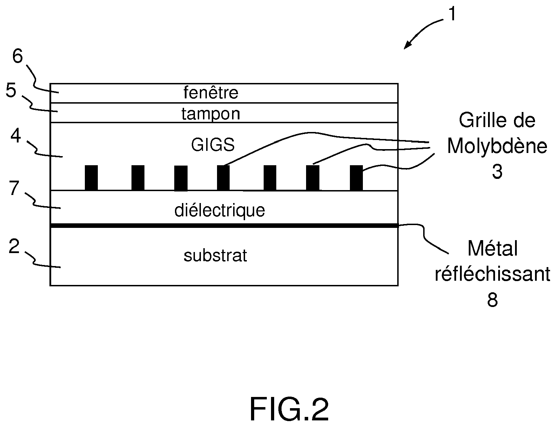

- les figures 1 et 2 illustrent schématiquement en vue de côté des agencements pour empilement de cellule photovoltaïque en couches minces, selon différents aspects de l'invention,
- la figure 1 bis illustre schématiquement en vue de dessus la grille de Molybdène, selon un aspect de l'invention et
- la figure 3 illustre schématiquement le procédé selon un aspect de l'invention.

Sur les différentes figures, les éléments ayant des références identiques sont identiques.

La figure 1 représente un agencement 1 pour empilement de cellule photovoltaïque en couches minces, qui comprend une couche de substrat 2 pour cellule photovoltaïque, une grille 3 de molybdène (couche de molybdène discontinue) disposé sur la couche de substrat 2, une couche ultra-mince 4 d'alliage d'absorbeur CIGS comprenant du cuivre, de l'indium, du gallium et du sélénium disposée sur la grille de molybdène, ainsi qu'une couche tampon 5 disposée sur la couche ultra-mince 4 et une couche fenêtre 6 disposée sur la couche tampon 5.

En variante, la couche ultra-mince d'absorbeur peut être du CZTS, même si les figures et la description ne représentent que le cas de la couche ultra-mince d'absorbeur en CIGS.

La couche de CIGS 4 a une épaisseur comprise entre 50 nm et 2.5 µm, la couche tampon 5 a une épaisseur comprise entre 10 nm et 200 nm, et la couche fenêtre 6 a une épaisseur comprise entre 50 nm et 500 nm.
La figure 1 bis illustre schématiquement la grille de molybdène 3 en vue de dessus, qui est une couche de Mo non continue (présence de trous) mais pour laquelle, quels que soient deux points définis dans la grille de Mo, la conductivité électrique entre ces deux points est assurée par le Mo. La figure 1 bis montre schématiquement un exemple de grille de Mo vue de dessus avec des trous circulaires de taille approximative de 1 µm de diamètre. Les trous ne sont pas nécessairement circulaires, ni identiques ou réguliers. Leur taille caractéristique peut varier de quelques nanomètres à plusieurs centaines de micromètres et les dimensions suivant deux axes perpendiculaires dans le plan ne sont pas nécessairement du même ordre de grandeur.

Sur la figure 2 est illustrée une variante de l'agencement 1 pour empilement de cellule photovoltaïque en couches minces, similaire à celui de la figure 1, qui comprend une couche optionnelle 7 de diélectrique disposée entre la couche de substrat 2 et la grille de molybdène, et une couche optionnelle 8 de métal réfléchissant disposée entre la couche de substrat 2 et la couche de diélectrique 7.

Le diélectrique 7 peut être à base de dioxyde de titane TiO₂ ou d'alumine Al₂O₃ permettant une meilleure passivation du contact arrière, typiquement d'une épaisseur comprise entre 1 nm et 1000 nm.

La grille de molybdène Mo a une épaisseur comprise entre 100 nm et 2 µm.

La fine couche de métal réfléchissant, de quelques nanomètres à une centaine de nanomètres, peut être en aluminium Al, en argent Ag, ou en or Au, ou en platine Pt, ou en molybdène Mo, permet d'augmenter le courant électrique dans la cellule comprenant du CIGS. Un métal alternatif plus réfléchissant que le molybdène Mo peut être utilisé car il sera protégé pendant l'étape de recuit de sélénisation par la couche diélectrique.

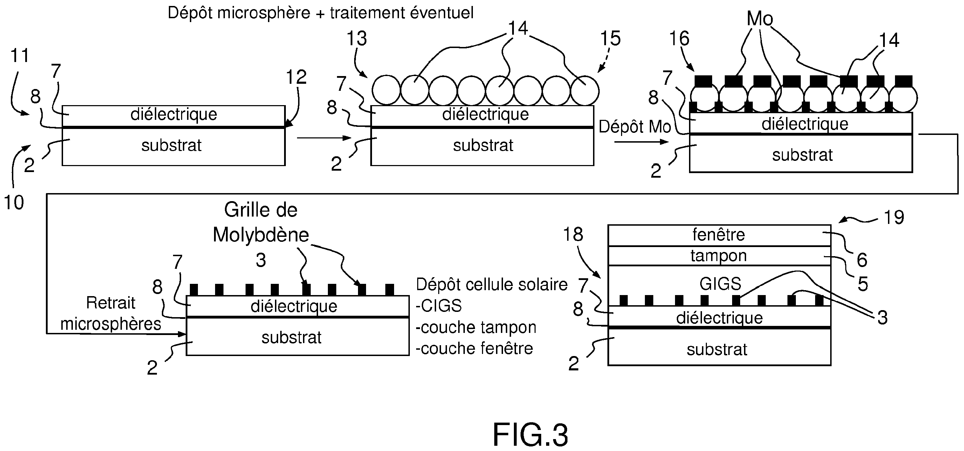

La figure 3 illustre le procédé selon un aspect de l'invention.

Le procédé commence par la fourniture 10 d'un substrat 2 pour cellule solaire ou photovoltaïque, sur lequel un dépôt 11 optionnel de diélectrique 7 est effectué sur la face supérieure du substrat 2. Le substrat 2 est généralement un substrat préparé pour cellule solaire, tel du verre ou du verre avec une barrière de diffusion, ou un substrat métallique avec une barrière de diffusion ou un substrat à base de polyimide.

Le dépôt 11 de diélectrique 7 peut se faire par des méthodes classiques (pulvérisation cathodique, ou dépôt de couche atomique ou ALD pour acronyme de "Atomic Layer Deposition" en langue anglaise, enduction centrifuge ou enduction par centrifugation ou "spin coating" en langue anglaise, ...). L'épaisseur du diélectrique 7 est comprise entre 1 nm et 1000 nm et typiquement de 100 nm.

En outre, une étape de dépôt 12 optionnel d'un métal réfléchissant 8, avant le dépôt 11 de la couche de diélectrique 7, la couche de métal réfléchissant 8 étant alors disposée entre la couche de substrat 2 et la couche de diélectrique 7.

Ensuite, est effectuée une étape de dépôt 13 d'un tapis de microsphères 14 sur la couche de diélectrique 7, ou sur le substrat 2 en cas d'absence de diélectrique 7.

La technologie de dépôt d'un film ordonné de microsphères en silice sur un substrat initial en défilement grâce à une technique équivalente à celle du Langmuir-Blodgett nommée Boostream©.

Une variante consiste à utiliser des particules non sphériques: fibre, disque, lentille, anneau... Les dimensions latérales des particules non sphériques sont similaires à celle des particules sphériques : avantageusement 1 µm, compris entre 100 nm et 5 µm.

L'utilisation de particules non sphériques permet de faire varier la forme des trous dans la couche de Mo et/ou le taux d'ouverture de cette couche de Mo (forme ou taux d'ouverture de la grille).

Une étape optionnelle 15 de traitement des microsphères 14 est effectuée après leur dépôt 13 et avant l'étape de dépôt 16 du molybdène Mo, modifiant la géométrie des microsphères, par exemple par gravure ionique réactive ou RIE comme acronyme de "reacite ion etching" en langue anglaise ou traitement thermique.

Le molybdène se dépose à la fois sur les microsphères 14 et entre leurs interstices sur la couche de diélectrique 7 ou sur le substrat 2 en cas d'absence de diélectrique 7.

L'épaisseur du dépôt de molybdène déposé est comprise entre 100 nm et 2000 nm, typiquement 500 nm.

Une étape 17 d'enlèvement des microsphères 14 permet d'obtenir une grille 3 de molybdène Mo, encore appelé molybdène texturé ou molybdène structuré.

Ensuite, on effectue un dépôt 18 d'une couche de CIGS (alliage de cuivre, d'indium, de gallium et de sélénium) ultra-mince d'une épaisseur comprise entre 50 nm et 2.5 µm, avantageusement de 500 nm, par une méthode connue, par exemple à base de co-évaporation, sélénisation de précurseurs déposés sous vide, sélénisation de précurseurs déposés hors-vide, ....

Une épaisseur de 500 nm a pour avantage de consommer 5 fois moins d'indium que la couche de 2.5 µm.

Des méthodes de réalisation de la couche de CIGS sont bien connues de l'homme de l'art, et sont par exemple décrites dans le document "Handbook of photovoltaic science and engineering", de Luque, A., et Hegedus, S. aux éditions John Wiley & Sons, notamment aux pages 559 à 564.

Deux grands types de méthodes de dépôt existent, le but final étant d'obtenir une couche de CIGS avec des rapports élémentaires suivant (0.75≤Cu/(In+Ga)≤0.95; 0.55≤In/(In+Ga)≤0.85 et 0.15≤Ga/(In+Ga)≤0.45) :
- la coévaporation, qui consiste à évaporer simultanément les éléments cuivre Cu, indium In, gallium Ga, et sélénium Se en chauffant le substrat à 550°C (450°C<T<650°C) pour obtenir le matériau désiré. Les taux d'évaporation des éléments peuvent être constants au cours du procédé (coévaporation en 1 étape) ou être variables pour obtenir des gradients de composition (coévaporation en trois étapes).
- la sélénisation de précurseurs, qui consiste à déposer des couches de précurseurs contenant au moins du cuivre Cu, de l'indium In et du gallium Ga dans les proportions suivantes 0.75≤Cu/(In+Ga)≤0.95; 0.55≤In/(In+Ga)≤0.85 et 0.15≤Ga/(In+Ga)≤0.45, par une méthode de dépôt sous vide (pulvérisation cathodique, évaporation, ...) ou hors vide (sol-gel (solution-gélification), electrodépôt, ...) à température comprise entre la température ambiante et 600°C puis à recuire cette couche de précurseurs sous une atmosphère contenant du sélénium Se (Se élémentaire, H2Se) et éventuellement du souffre S à une température de 550°C (450°C<T<650°C), à pression proche de la pression atmosphérique (0.1 mBar<P<2bars). Le recuit est typiquement un recuit du type recuit rapide.

Enfin, on effectue une étape de dépôt 19 d'une couche tampon 5 (CdS, ZnS, In2S3) et une couche fenêtre 6 (ZnO/ZnO:Al, ITO, ...) pour obtenir une cellule solaire.

Des fabrications de la cellule photovoltaïque à base de CIGS sont connues de l'homme de l'art et décrites par exemple dans le document "Handbook of photovoltaic science and engineering", de Luque, A., et Hegedus, S. aux éditions John Wiley & Sons, notamment aux pages 564 à 571. Elles comportent notamment :
- un dépôt 19 d'une couche tampon 5 d'épaisseur et comprise entre 10 nm et 200 nm, et en l'espèce 50 nm à base de sulfure de cadmium CdS, de sulfure de zinc ZnS, de sulfure d'indium In2S3 ou autre par bain chimique ou par dépôt sous vide (pulvérisation cathodique, ou ALD, ...)
- un dépôt 19 d'une couche fenêtre 6 d'épaisseur comprise entre 50 nm et 500 nm, en l'espèce 200 nm, par pulvérisation cathodique. Il s'agit généralement d'une bi-couche (ZnO/ZnO:Al, ZnO/ITO, ...). D'autres méthodes de dépôts (dépôt par bain chimique ou CBD pour acronyme de "chemical bath deposition" en langue anglaise, ou ALD) ou d'autres matériaux sont également possibles (nanofils métalliques, SnO2 :F, ...)

## Revendications

1. Agencement (1) pour empilement de cellule photovoltaïque en couches minces comprenant une couche de substrat (2) pour cellule photovoltaïque et une grille de molybdène (3) disposée sur la couche de substrat (2), une couche ultra-mince d'absorbeur de lumière (4) recouvrant la grille de molybdène (3) et comblant les trous de la grille de molybdène (3), ainsi qu'une couche tampon (5) disposée sur la couche ultra-mince d'absorbeur de lumière, et une couche fenêtre disposée sur la couche tampon.

2. Agencement (1) selon la revendication 1, dans lequel la couche ultra-mince d'absorbeur de lumière est en alliage (4) de cuivre, d'indium, de gallium et de sélénium.

3. Agencement (1) selon la revendication 1, dans lequel la couche ultra-mince d'absorbeur de lumière est en alliage de cuivre, de zinc, d'étain, ainsi que de sélénium et/ou de soufre.

4. Agencement (1) selon l'une des revendications 1 à 3, comprenant une couche de diélectrique (7) disposée entre la couche de substrat (2) et la grille de molybdène (3).

5. Agencement selon la revendication 4, comprenant une couche de métal réfléchissant (8) disposée entre la couche de substrat (2) et la couche de diélectrique (7).

6. Procédé de fabrication d'un agencement (1) pour empilement de cellule photovoltaïque en couches minces comprenant les étapes de :
- fourniture (10) d'un substrat (2) pour cellule photovoltaïque;
- dépôt (13) d'un tapis de microsphères (14) sur ledit substrat (2);
- dépôt (16) de molybdène sur le tapis de microsphères (14) dont une partie se glisse dans les interstices séparant les microsphères (14);
- enlèvement (17) des microsphères (14) laissant une grille de molybdène (3);
- dépôt (18) d'une couche ultra-mince d'absorbeur de lumière sur la grille de molybdène; et
- dépôt (19) d'une couche tampon (5) et d'une couche fenêtre (6) sur la couche ultra-mince d'absorbeur de lumière.

7. Procédé selon la revendication 6, comprenant, en outre, une étape de traitement (15) des microsphères (14), après leur dépôt (13) et avant l'étape de dépôt (16) de molybdène, modifiant la géométrie des microsphères (14).

8. Procédé selon la revendication 7, dans lequel l'étape de traitement (15) des microsphères (14) comprend une gravure et/ou un recuit.

9. Procédé selon l'une des revendications 6 à 8, comprenant, en outre, une étape de dépôt (11) d'une couche de diélectrique (7) sur le substrat (2) avant le dépôt (13) des microsphères (14); la couche de diélectrique (7) se trouvant alors entre le substrat (2) et le tapis de microsphères (14).

10. Procédé selon la revendication 9, comprenant, en outre, une étape de dépôt (12) d'un métal réfléchissant (8), avant le dépôt (11) de la couche de diélectrique (7), la couche de métal réfléchissant (8) étant alors disposée entre la couche de substrat (2) et la couche de diélectrique (7).

11. Procédé selon l'une des revendications 6 à 10, dans lequel le dépôt (16) de la couche de molybdène sur les microsphères (14) est fait sur une épaisseur comprise entre 100 et 2000 nm.

12. Procédé selon la revendication 11, dans lequel le dépôt (16) de la couche de molybdène sur les microsphères (14) est fait sur une épaisseur de sensiblement 500 nm.

13. Procédé selon l'une des revendications 6 à 12, dans lequel le dépôt (2) de la couche de diélectrique (7) est à base de dioxyde de titane TiO₂ ou d'alumine Al₂O₃.

14. Procédé selon l'une des revendications 6 à 13, dans lequel le dépôt (13) du tapis de microsphères (14) met en oeuvre des microsphères (14) de diamètre compris entre 100 nm et 5 µm.

15. Procédé selon la revendication 14, dans lequel le dépôt (13) du tapis de microsphères (14) met en oeuvre des microsphères (14) de diamètre de sensiblement 1 µm.

16. Procédé selon l'une des revendications 6 à 15, dans lequel l'enlèvement (17) des microsphères (14) met en oeuvre un bain d'ultra-sons dans l'eau.
